# EUROPEAN PATENT SPECIFICATION

(11) **EP 3 307 037 B1**
(45) Date of publication and mention of the grant of the patent: **28.08.2019**
(21) Application number: 17167332.0
(22) Date of filing: 20.04.2017
(51) Int. Cl.: A47B 88/427, A47B 88/423

(54) **SLIDE RAIL ASSEMBLY**
GLEITSCHIENENANORDNUNG
ENSEMBLE DE RAIL DE GLISSEMENT

(30) Priority: 05.10.2016 TW 105132508
(43) Date of publication of application: 11.04.2018
(73) Proprietor: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Chang, Wei-Chen, 821 Kaohsiung City (TW); Wang, Chun-Chiang, 821 Kaohsiung City (TW)
(74) Representative: Becker Kurig Straus

(56) References cited:
- EP-A1- 2 182 788
- EP-A1- 2 989 930
- US-A1- 2005 017 614
- US-A1- 2006 029 304

## Description

### Field of the Invention

The present invention is related to a slide rail assembly.

### Background of the Invention

A three-section slide rail assembly comprises a first rail, a second rail and a third rail. Wherein, the second rail is configured to extend a traveling distance of the third rail relative to the first rail, and the third rail is usually configured to mount a carried object.

When the third rail carries the carried object to move along a direction relative to the second rail and the first rail, strength of the third rail for carrying the carried object may not be enough due to the carried object being overweight, so as to deform or damage the third rail during long term use.

On the other hand, US patent number US 6, 938, 967 B2 of Dubon et al. discloses a drop-in mounting method for mounting a carried object (such as a chassis) to a slide rail assembly. According to the mounting method, the slide rail assembly needs to be completely pulled out of a rack, and then the chassis is lifted to be higher than the slide rail assembly. Thereafter, a plurality of mounting posts at both sides of the chassis are respectively aligned to a plurality of mounting features of the slide rail assembly to be further dropped therein, so as to mount the chassis to the slide rail assembly. The aforementioned mounting method is usually used to mount the chassis in a limited space, and rails of the slide rail assembly are not detachable from each other. However, the aforementioned mounting method has some drawbacks. For example, when the slide rail assembly is located near a top position of the rack, it is inconvenient to lift the chassis to be higher than the slide rail assembly during a process of mounting the chassis to the slide rail assembly.

US patent number US 8,622,492 B2 of Chen et al. discloses another method for mounting a carried object (such as a chassis) to a slide rail assembly. According to the mounting method, a rail (such as an inner rail) of the slide rail assembly is required to be pulled out and detached from the slide rail assembly, in order to mount the inner rail to a side of the chassis. Thereafter, the chassis is mounted to the slide rail assembly by inserting the inner rail into the slide rail assembly. Such mounting method requires a larger space than the mounting method of the previous patent does, and is not applicable to a smaller room. An advantage of Chen's mounting method is that when the slide rail assembly is located near the top position of the rack, the chassis can be mounted to the slide rail assembly by aligning and inserting the inner rail to the slide rail assembly without lifting the chassis to be higher than the slide rail assembly.

EP 2 989 930 A1 (KING SLIDE WORKS CO LTD [TW]; KING SLIDE TECHNOLOGY CO LTD [TW]) 2 March 2016 (2016-03-02) discloses a slide rail assembly of which two rails may be synchronously moved and when one of the rails is moved to a position, the rail may be remained at the position while the other rail may be further moved forward.

Each of the two mounting methods has its drawback. The present invention combines the advantages of both mounting methods to provide more product options in the industry.

### Summary of the Invention

This in mind, the present invention aims at providing a slide rail assembly.

This is achieved by a slide rail assembly according to claim 1. The dependent claims pertain to corresponding further developments and improvements.

As will be seen more clearly from the detailed description following below, the claimed slide rail assembly is configured to mount a chassis. The slide rail assembly comprises a first rail, a second rail and a third rail. The second rail is movable relative to the first rail. The second rail has a first aperture. The third rail is detachably connected to the second rail. The third rail has a plurality of mounting holes and each of the mounting holes has a vertical hole part. Wherein, when the third rail is located at an extension position relative to the second rail, the first aperture of the second rail and the vertical hole parts of the plurality of mounting holes of the third rail are configured to mount the chassis.

As will be seen more clearly from the detailed description following below, the claimed slide rail assembly comprises a first rail, a second rail, a third rail and a sliding auxiliary device. The second rail is movable relative to the first rail. The second rail has a first aperture. The third rail is movable relative to the second rail. The third rail has a plurality of mounting holes . The sliding auxiliary device is arranged between the second rail and the third rail. The sliding auxiliary device has a second aperture. Wherein, when the third rail is located at an extension position relative to the second rail, the first aperture, the second aperture and one of the mounting holes of the third rail are communicated with each other.

### Brief Description of the Drawings

In the following, the invention is further illustrated by way of example, taking reference to the accompanying drawings thereof:
FIG. 1 is a diagram showing slide rail assemblies configured to mount a carried object to a rack according to an embodiment of the present invention;
FIG. 2 is an exploded view of the slide rail assembly comprising a first rail, a second rail and a third rail according to an embodiment of the present invention;
FIG. 3 is an enlarged view of an area A of FIG. 2;
FIG. 4 is an enlarged view of an area B of FIG. 2;
FIG. 5 is an enlarged view of an area C of FIG. 2;
FIG. 6 is a diagram showing the third rail of the slide rail assembly according to an embodiment of the present invention;
FIG. 6A is an enlarged view of an area A of FIG. 6;
FIG. 6B is an enlarged view of an area B of FIG. 6;
FIG. 7 is a cross-sectional view of the third rail of the slide rail assembly according to an embodiment of the present invention;
FIG. 8 is a diagram showing the slide rail assembly in a retracted state according to an embodiment of the present invention;
FIG. 9 is a diagram showing the second rail and the third rail of the slide rail assembly being synchronously moved relative to the first rail along a first direction according to an embodiment of the present invention;
FIG. 10 is a diagram showing an engaging member of the slide rail assembly being moved along a releasing feature according to an embodiment of the present invention;
FIG. 11 is an enlarged view of an area A of FIG. 10;
FIG. 12 is a diagram showing the second rail of the slide rail assembly being no longer synchronously moved with the third rail according to an embodiment of the present invention;
FIG. 13 is an enlarged view of an area A of FIG. 12;
FIG. 14 is a diagram showing the engaging member of the slide rail assembly being blocked by the releasing feature in a state according to an embodiment of the present invention;
FIG. 15 is an enlarged view of an area A of FIG. 14;
FIG. 16 is a diagram showing the third rail of the slide rail assembly being moved relative to the second rail along a second direction and contacting the engaging member according to an embodiment of the present invention;
FIG. 17 is a diagram showing the third rail of the slide rail assembly configured to drive the engaging member to be no longer blocked by the releasing member according to an embodiment of the present invention;
FIG. 18 is an enlarged view of an area A of FIG. 17;
FIG. 19 is a diagram showing the third rail of the slide rail assembly in the retracted state relative to the second rail according to an embodiment of the present invention;
FIG. 20 is a diagram showing the third rail of the slide rail assembly being moved relative to the second rail along the first direction to drive a sliding auxiliary device to move according to an embodiment of the present invention;
FIG. 21 is a diagram showing the third rail of the slide rail assembly being moved relative to the second rail along the first direction to drive the sliding auxiliary device to move according to an embodiment of the present invention;
FIG. 22 is a diagram showing a blocking feature configured to block a first operating piece when the third rail of the slide rail assembly is moved relative to the second rail along the first direction to a position according to an embodiment of the present invention;
FIG. 23 is a diagram showing the first operating piece being no longer blocked by the blocking feature according to an embodiment of the present invention;
FIG. 24 is a diagram showing the third rail of the slide rail assembly being detached from the second rail according to an embodiment of the present invention;
FIG. 25 is a diagram showing the blocking feature configured to block a second operating piece when the third rail of the slide rail assembly is moved to the position according to an embodiment of the present invention;
FIG. 26 is a diagram showing the second operating piece of the slide rail assembly being no longer blocked by the blocking feature according to an embodiment of the present invention;
FIG. 27 is a diagram showing the slide rail assembly in an extended state and the third rail configured to mount a carried object according to an embodiment of the present invention;
FIG. 28 is an enlarged view of an area A of FIG. 27;
FIG. 29 is a diagram showing the carried being mounted to the third rail of the slide rail assembly according to an embodiment of the present invention; and
FIG. 30 is a diagram showing the carried object being mounted to the third rail with the third rail being going to be mounted to the second rail according to an embodiment of the present invention.

### Detailed Description

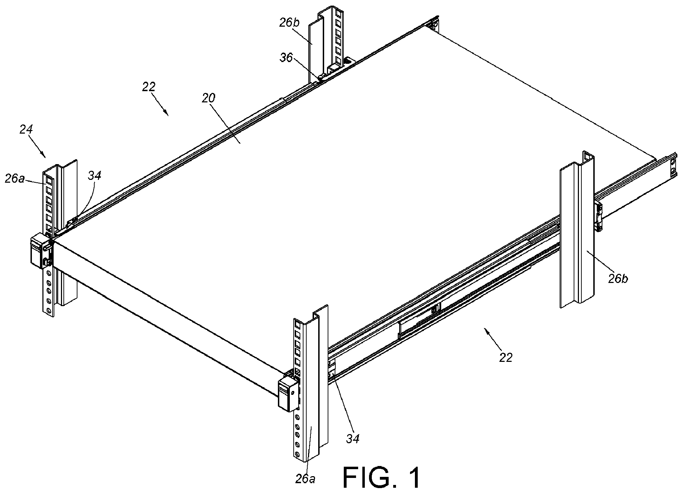

As shown in FIG. 1, a carried object 20 is mounted to a rack 24 through a pair of slide rail assemblies 22. The carried object 20 can be an electronic apparatus or a chassis. The rack 24 comprises a pair of first post 26a and a pair of second post 26b. Wherein, two portions of each of the slide rail assemblies 22 are respectively mounted to the first post 26a and the second post 26b through a first bracket device 34 and a second bracket device 36. Such arrangement is well known to those skilled in the art. For simplification, no further illustration is provided.

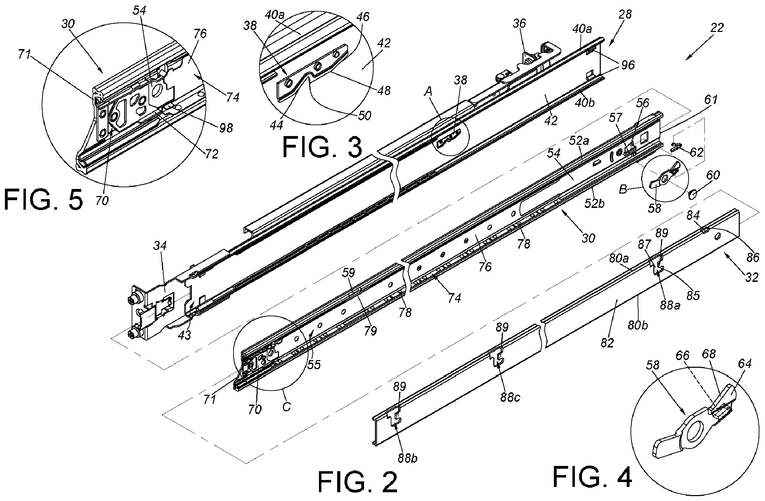

As shown in FIG. 2, the slide rail assembly 22 comprises a first rail 28, a second rail 30 and a third rail 32. The first rail 28 is arranged with the first bracket device 34 and the second bracket device 36. The first rail 28 comprises a releasing feature 38. The releasing feature 38 can be an additional component mounted to the first rail 28; or the releasing feature 38 can be integrally formed on the first rail 28. Furthermore, the first rail 28 comprises a first wall 40a, a second wall 40b, and a side wall 42 connected between the first wall 40a and the second wall 40b. A first passage 43 is defined by the first wall 40a, the second wall 40b and the side wall 42 of the first rail 28.

In the present embodiment, the releasing feature 38 is arranged on the side wall 42 of the first rail 28. Preferably, as shown in FIG. 3, the releasing feature 38 comprises a first guiding part 44, a second guiding part 46, a linear part 48 and a blocking part 50. The blocking part 50 and the linear part 48 are located between the first guiding part 44 and the second guiding part 46. Preferably, each of the first guiding part 44 and the second guiding part 46 has an inclined face or an arc face. The blocking part 50 has a wall located between the first guiding part 44 and the linear part 48. Wherein, the blocking part 50 is recessed relative to the linear part 48.

The second rail 30 (or called as middle rail) is movably mounted to the first rail 28 inside the first passage 43. In particular, the second rail 30 has a first wall 52a, a second wall 52b, and a side wall 54 connected between the first wall 52a and the second wall 52b. A second passage 55 is defined by the first wall 52a, the second wall 52b and the side wall 54 of the second rail 30. Preferably, the side wall 54 of the second rail 30 has a through hole 56 facing toward the side wall 42 of the first rail 28. The second rail 30 has a supporting wall 57 adjacent to the through hole 56. In addition, the second rail 30 has a first aperture 59. In the present embodiment, the first aperture 59 is arranged on the first wall 52a. Furthermore, the slide rail assembly 22 comprises an engaging member 58 movably mounted to the second rail 30. In the present embodiment, the engaging member 58 is pivoted to the side wall 54 of the second rail 30 by a pivoting member 60, and the engaging member 58 is adjacent to a rear end 61 of the second rail 30. The slide rail assembly 22 further comprises an elastic member 62 configured to provide an elastic force to the engaging member 58. For example, the elastic member 62 is mounted between the supporting wall 57 and the engaging member 58. As shown in FIG. 4, the engaging member 58 comprises an engaging part 64. Preferably, the engaging member 58 further comprises an extension part 66 and a disengaging part 68. Wherein, the extension part 66 is located at a position corresponding to the through hole 56 of the second rail 30. The disengaging part 68 has an inclined face or an arc face. Preferably, the second rail 30 comprises a blocking feature 70. In the present embodiment, the blocking feature 70 is arranged on the side wall 54 and adjacent to a front end 71 of the second rail 30. The blocking feature 70 can be an additional component mounted to the second rail 30; or the blocking feature 70 can be integrally formed on the second rail 30. Furthermore, as shown in FIG. 5, the blocking feature 70 has a blocking section 72. The blocking section 72 is protruded relative to the side wall 54 of the second rail 30. In the present embodiment, the slide rail assembly 22 further comprises a sliding auxiliary device 74 movably mounted to the second rail 30 inside the second passage 55. The sliding auxiliary device 74 comprises a holding base 76 and a plurality of rolling members 78 arranged on the holding base 76. The plurality of rolling members 78 can be balls or rollers. Preferably, the holding base 76 of the sliding auxiliary device 74 has a second aperture 79. When the sliding auxiliary device 74 is moved to a position, the second aperture 79 is located at a position corresponding to the first aperture 59 of the second rail 30.

The third rail 32 (or called as inner rail) is movably mounted to the second rail 30 inside the second passage 55. In particular, the third rail 32 has a first wall 80a, a second wall 80b, and a side wall 82 connected between the first wall 80a and the second wall 80b. Preferably, the third rail 32 has an opening 84 and at least one rail wall 86 adjacent to the opening 84. In the present embodiment, the opening 84 is arranged on the first wall 80a. In addition, the third rail 32 has a plurality of mounting holes spaced from each other. In the present embodiment, the third rail 32 has a first mounting hole 88a, a second mounting hole 88b and a third mounting hole 88c. The mounting holes 88a, 88b, 88c are configured to mount the carried object 20. Wherein, at least one of the mounting holes 88a, 88b, 88c is substantially L-shaped or J-shaped. In the present embodiment, the mounting holes 88a, 88b, 88c have identical shapes, but the present invention is not limited thereto. Furthermore, the third rail 32 comprises a plurality of extension features 89. Each of the extension features 89 defines a vertical hole part 87 and a longitudinal hole part 85 of the corresponding mounting hole, wherein the vertical hole part 87 is communicated with the longitudinal hole part 85. The extension feature 89 can be a protrusion located between the vertical hole part 87 and the longitudinal hole part 85.

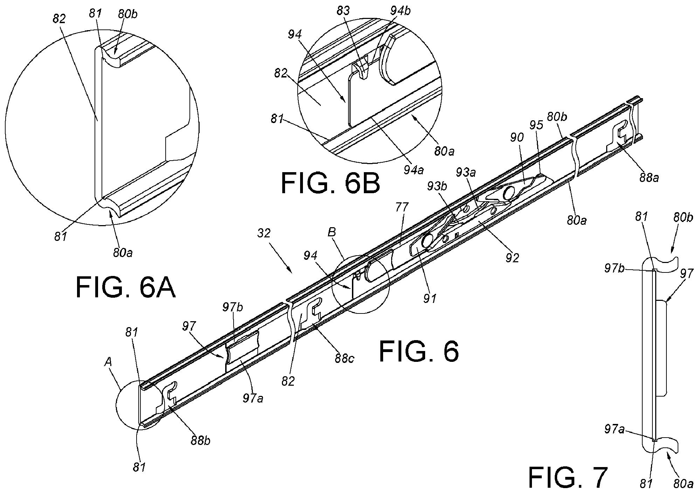

FIG. 6 is a diagram showing one side of the side wall 82 of the third rail 32 (such as an inner side or a side facing toward the second rail 30) . Compared with FIG. 2, FIG. 6 shows the first wall 80a, the second wall 80b and the mounting holes 88a, 88b, 88c of the third rail 32 in an upside down state. Furthermore, the slide rail assembly 22 further comprises a first operating piece 90 movably mounted to the third rail 32. The first operating piece 90 can be operated to be in different working states. In the present embodiment, the first operating piece 90 is pivoted to the third rail 32. Preferably, the slide rail assembly 22 further comprises a supporting base 92 mounted to the third rail 32. The supporting base 92 comprises a first elastic part 93a configured to provide an elastic force to one end of the first operating piece 90, so as to hold the first operating piece 90 in a first working state. Preferably, the first operating piece 90 can be operated through a first operating rod 94. The first operating rod 94 comprises a longitudinal rod part arranged substantially along a longitudinal direction of the third rail 32. The first operating rod 94 further comprises an actuating part 95 located at a position corresponding to another end of the first operating piece 90 for driving the first operating piece 90 to be no longer in the first working state. Preferably, as shown in FIG. 6 and FIG. 6A, at least one of the first wall 80a and the second wall 80b of the third rail 32 is arranged with a groove 81. In the present embodiment, both the first wall 80a and the second wall 80b are arranged with the grooves 81 respectively. Each of the grooves 81 is adjacent to the side wall 82, but the present invention is not limited thereto.

As shown in FIG. 6B, the first operating rod 94 has one side 94a partially located in the groove 81 of the first wall 80a of the third rail 32. An inverted L-shaped protrusion part 83 is arranged on the side wall 82 of the third rail 32 and configured to abut against another side 94b of the first operating rod 94 for preventing the first operating rod 94 from excessively tilting away from a plane of the side wall 82 of the third rail 32 due to tolerance or deformation.

As shown in FIG. 6, the slide rail assembly 22 further comprises a second operating piece 91 movably mounted, such as pivoted, to the third rail 32. The supporting base 92 further comprises a second elastic part 93b configured to provide an elastic force to one end of the second operating piece 91, so as to hold the second operating piece 91 in a first working state. Preferably, the slide rail assembly 22 further comprises a second operating rod 97 having a longitudinal rod part arranged substantially along the longitudinal direction of the third rail 32. Wherein, the second operating rod 97 comprises a driving part 77 corresponding to the second operating piece 91 for driving the second operating piece 91 to be no longer in the first working state. The second operating rod 97 has at least one side partially located in the groove 81 of the third rail 32. In the present embodiment, the second operating rod 97 has two sides 97a, 97b partially located in the grooves 81 of the third rail 32. (please also refer to FIG. 7).

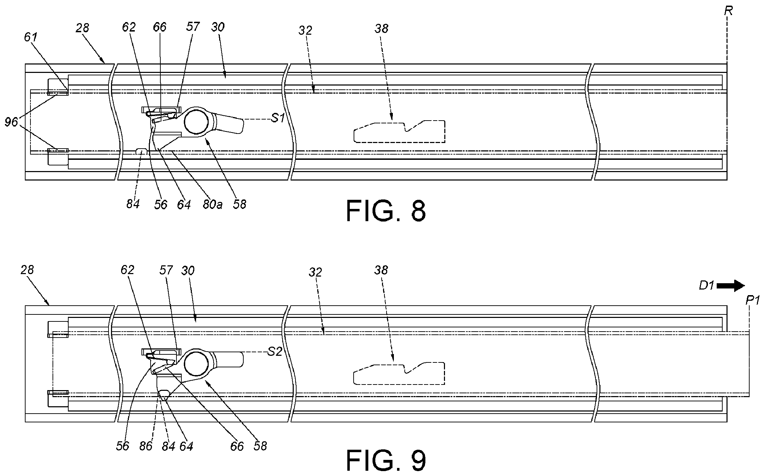

As shown in FIG. 8, the extension part 66 of the engaging member 58 penetrates through the through hole 56 of the second rail 30, and the elastic member 62 is arranged between the engaging member 58 and the supporting wall 57 of the second rail 30, so as to hold the engaging member 58 in a first state S1 relative to the second rail 30. Furthermore, when the slide rail assembly 22 is in a retracted state, the second rail 30 is located at a retracted position relative to the first rail 28, and the rear end 61 of the second rail 30 is located at a position corresponding to at least one rear stopper 96 of the first rail 28. On the other hand, the third rail 32 is also located at a retracted position R relative to the second rail 30. Wherein, the engaging member 58 is driven to abut against one of the first wall 80a and the second wall 80b of the third rail 32 by the elastic member 62. For example, the engaging member 58 is driven to abut against the first wall 80a and held in the first state S1 by the elastic member 62, and the elastic member 62 accumulates an elastic force.

As shown in FIG. 9, when the third rail 32 is moved relative to the second rail 30 from the retracted position R to a first predetermined position P1 along a first direction D1, the engaging member 58 is configured to engage with the third rail 32. In particular, when the third rail 32 is located at the first predetermined position P1 relative to the second rail 30, the engaging member 58 is rotated from the first state S1 to a second state S2 in response to the elastic force released by the elastic member 62, such that the engaging part 64 of the engaging member 58 enters the opening 84 of the third rail 32, and the engaging part 64 is located at a position corresponding to the at least one rail wall 86.

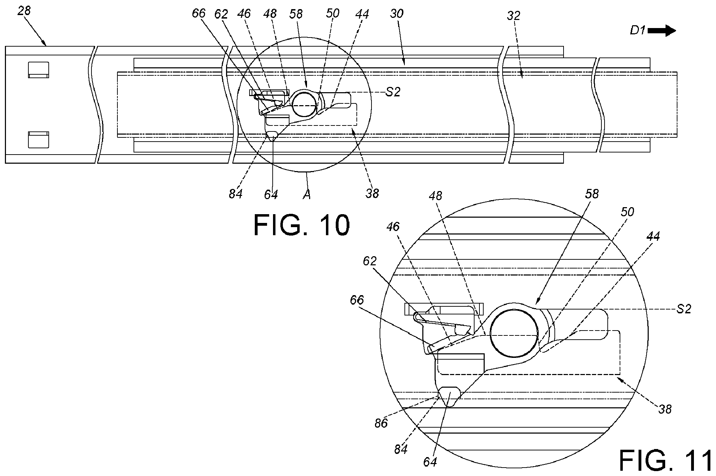

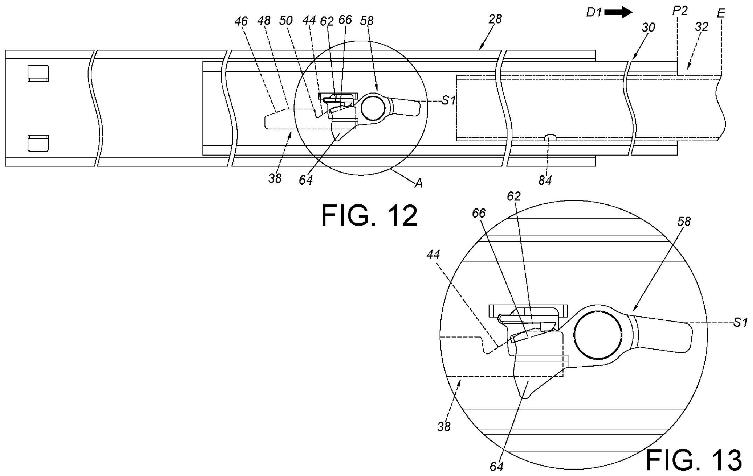

As shown in FIG. 10, FIG. 11 and FIG. 12, when the engaging member 58 is engaged with the third rail 32, the second rail 30 is driven by the third rail 32 to synchronously move. That is to say, the second rail 30 and the third rail 32 can be synchronously moved relative to the first rail 28 along the first direction D1. When the second rail 30 is synchronously moved with the third rail 32 to a second predetermined position P2, the releasing feature 38 of the first rail 28 is configured to disengage the engaging member 58 from the third rail 32. In particular, in a process of the second rail 30 being synchronously moved with the third rail 32, the extension part 66 of the engaging member 58 is moved along the second guiding part 46, the linear part 48, the blocking part 50 and the first guiding part 44 of the releasing feature 38. In particular, when the extension part 66 of the engaging member 58 sequentially passes through the second guiding part 46, the linear part 48 and the blocking part 50 until the second rail 30 is moved relative to the first rail 28 to the second predetermined position P2, the engaging member 58 is guided by the first guiding part 44 through the extension part 66 to be no longer in the second state S2. For example, the engaging member 58 is moved back to the first state S1 from the second state S2 (please also refer to FIG. 13), such that the engaging part 64 of the engaging member 58 is disengaged from the opening 84 of the third rail 32. After the engaging member 58 is disengaged from the third rail 32, the third rail 32 is able to be moved relative to the second rail 30 along the first direction D1 to an extension position E.

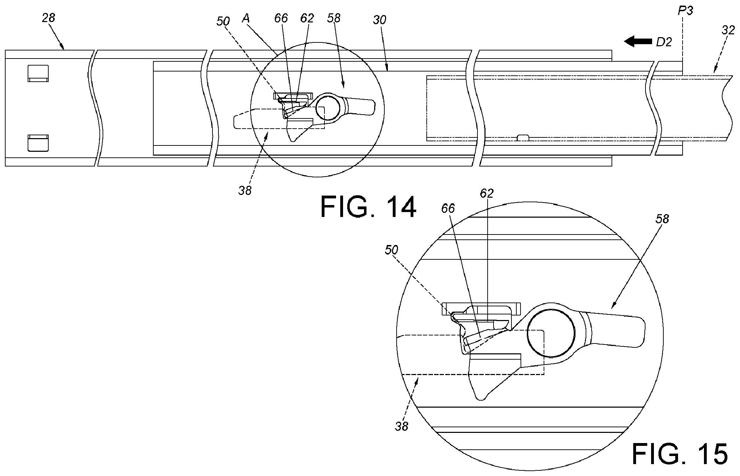

As shown in FIG. 12 and FIG. 14, when the second rail 30 is moved relative to the first rail 28 from the second predetermined position P2 to a third predetermined position P3 along a second direction D2 (opposite to the first direction D1), the extension part 66 of the engaging member 58 is blocked by the blocking part 50 of the releasing feature 38 (please also refer to FIG. 15) for preventing the second rail 30 from being moved relative to the first rail 28 along the second direction D2.

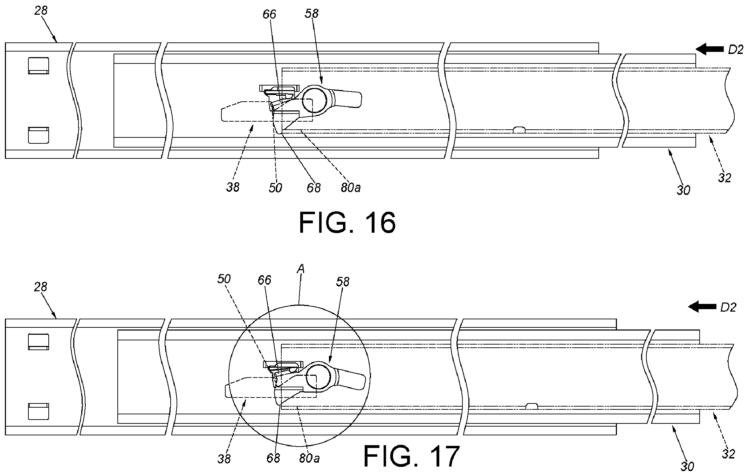

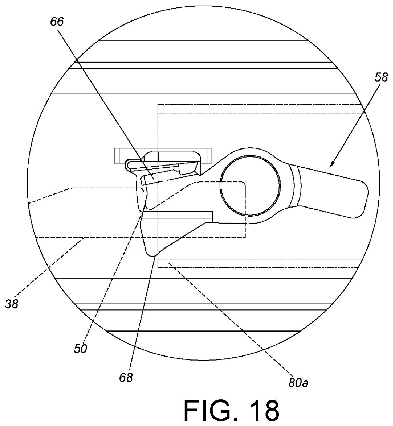

As shown in FIG. 16 and FIG. 17, when the extension part 66 of the engaging member 58 is blocked by the blocking part 50 of the releasing feature 38, and the third rail 32 is moved relative to the second rail 30 from the extension position E along the second direction D2, the third rail 32 is configured to drive the engaging member 58 for moving the extension part 66 of the engaging member 58 to be no longer blocked by the blocking part 50 of the releasing feature 38. In the present embodiment, the first wall 80a of the third rail 32 is configured to drive the engaging member 58 to rotate through the disengaging part 68, in order to detach the extension part 66 from the blocking part 50 of the releasing feature 38 (please also refer to FIG. 18), so as to allow the second rail 30 to be movable relative to the first rail 28 along the second direction D2.

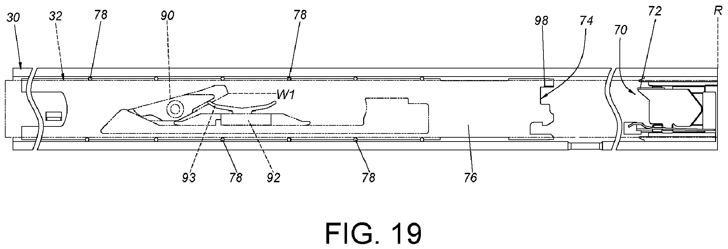

As shown in FIG. 19, the sliding auxiliary device 74 is arranged between the second rail 30 and the third rail 32 for improving smoothness of movement of the third rail 32 relative to the second rail 30. Wherein, the plurality of rolling members 78 on the holding base 76 are in rolling contact with the second rail 30 and the third rail 32. In addition, the holding base 76 comprises a contact part 98. Wherein, the contact part 98 and the blocking section 72 of the blocking feature 70 of the second rail 30 are not aligned along a longitudinal direction of the second rail 30. On the other hand, the first operating piece 90 corresponds to the contact part 98 of the holding base 76 when being in the first working state W1.

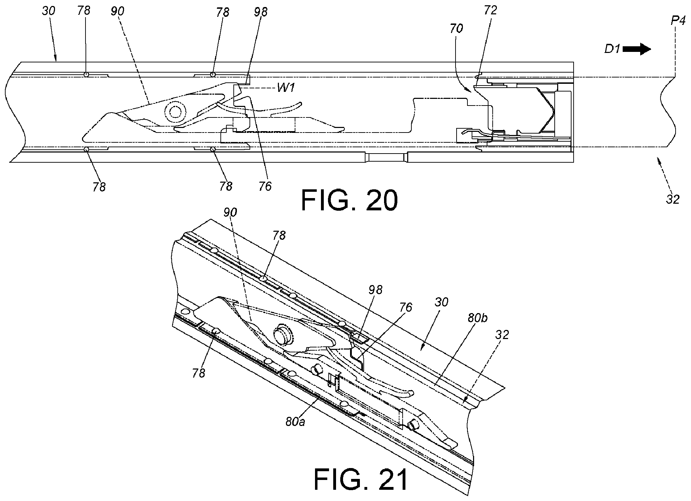

As shown in FIG. 20, when the engaging member 58 is disengaged from the third rail 32 to end the synchronous movement of the second rail 30 and the third rail 32 (please also refer to FIG. 12), the third rail 32 can be further moved relative to the second rail 30 along the first direction D1 (the first rail 28, the second operating piece 91 and the second operating rod 97 are omitted in the figure). When the third rail 32 is moved to a fourth predetermined position P4, the first operating piece 90 abuts against the contact part 98 of the holding base 76 in the first working state W1, in order to force the sliding auxiliary device 74 to synchronously move with the third rail 32 along the first direction D1 (please also refer to FIG. 21); or, the sliding auxiliary device 74 can be moved with the third rail 32 asynchronously along the first direction D1. The way of movement of the sliding auxiliary device 74 along the first direction D1 is not limited thereto. In addition, as shown in FIG. 21, the first wall 80a and the second wall 80b of the third rail 32 respectively contact the plurality of rolling members 78 of the holding base 76.

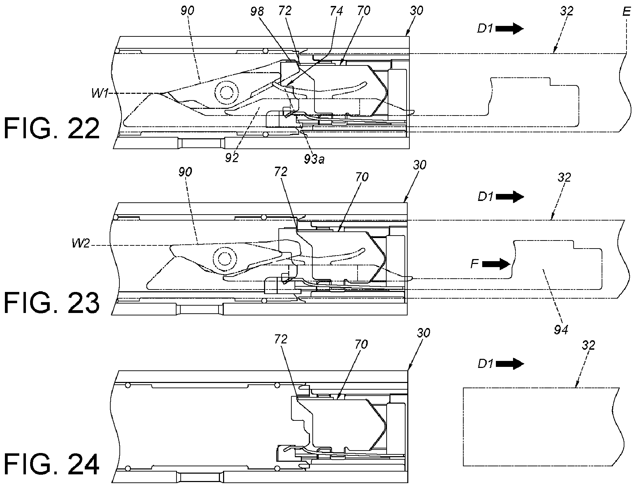

As shown in FIG. 22, when the third rail 32 is moved relative to the second rail 30 along the first direction D1 to the extension position E, the sliding auxiliary device 74 is driven by the first operating piece 90 to move to a position adjacent to the blocking feature 70 of the second rail 30. The first operating piece 90 abuts against a first side of the blocking section 72 of the blocking feature 70, such that the third rail 32 cannot be further moved relative to the second rail 30 along the first direction D1.

As shown in FIG. 23 and FIG. 24, in order to detach the third rail 32 from the second rail 30, a user can apply a force F along the first direction D1 to the first operating rod 94 for operating the first operating piece 90 to switch from the first working state W1 to a second working state W2. As such, the first operating piece 90 is no longer blocked by the blocking section 72 of the blocking feature 70. Therefore, the third rail 32 can be detached from the second rail 30 along the first direction D1. That is to say, the third rail 32 is detachably connected to the second rail 30.

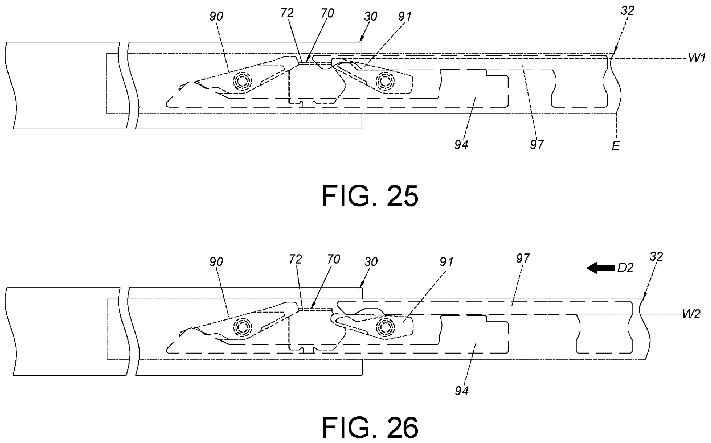

As shown in FIG. 25, in the present embodiment, when the third rail 32 is moved relative to the second rail 30 to the extension position E (the first rail 28 and the supporting base 92 are omitted in FIG. 25), the second operating piece 91 is in the first working state W1 and located at a second side of the blocking section 72 of the blocking feature 70. In such state, the third rail 32 is not movable relative to the second rail 30 along the second direction D2.

As shown in FIG. 26, in order to move the third rail 32 relative to the second rail 30 along the second direction D2 when the third rail 32 is located at the extension position E, the user can operate the second operating piece 91 through the second operating rod 97 to switch the second operating piece 91 from the first working state W1 to a second working state W2. As such, the second operating piece 91 is no longer located at the second side of the blocking section 72 of the blocking feature 70. Therefore the third rail 32 can be retracted relative to the second rail 30 from the extension position E along the second direction D2.

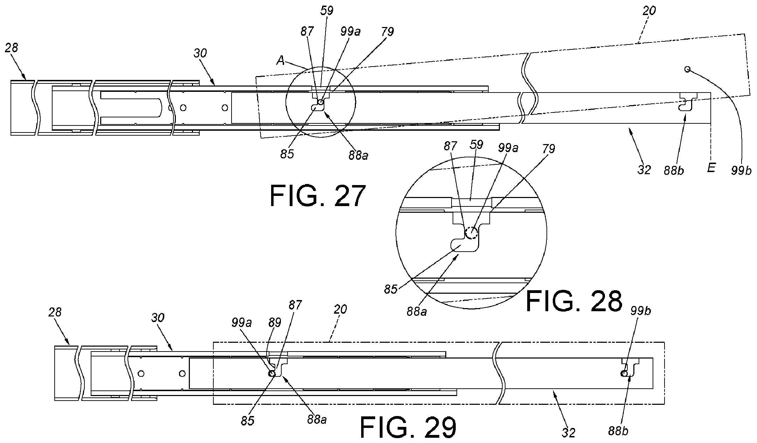

As shown in FIG. 27, the carried object 20 comprises a plurality of mounting parts, such as a first mounting part 99a and a second mounting part 99b. The plurality of mounting parts 99a, 99b can be mounted to the corresponding mounting holes 88a, 88b of the third rail 32. Furthermore, the slide rail assembly 22 of the present invention is configured to mount the carried object 20 in at least two different mounting ways.

In a first mounting way, when the second rail 30 and the third rail 32 are moved relative to the first rail 28 along the first direction D1, and the third rail 32 is located at the extension position E relative to the second rail 30, the first aperture 59, the second aperture 79 and one of the mounting holes of the third rail 32 (such as the first mounting hole 88a) are located at positions corresponding to each other, or communicated with each other (please also refer to FIG. 28). Therefore, the user can take the carried object 20 to allow the first mounting part 99a of the carried object 20 to enter the longitudinal hole part 85 from the vertical hole part 87 of the first mounting hole 88a (please also refer to FIG. 29). Thereafter, the other mounting part, such as the second mounting part 99b, is mounted to the second mounting hole 88b. Thus, the first aperture 59 of the second rail 30 and the vertical hole parts 87 of the plurality of mounting holes 88a, 88b are configured to mount the carried object 20 (such as the chassis).

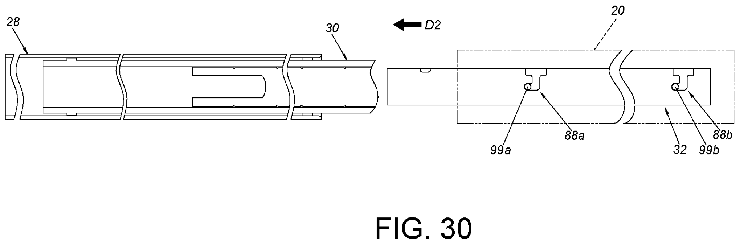

As shown in FIG. 30, in a second mounting way, after the third rail 32 is detached from the second rail 30, the user can take the carried object 20 to correspondingly mount the mounting parts 99a, 99b to the mounting holes 88a, 88b of the third rail 32. Thereafter, the carried object 20 can be mounted to the slide rail assembly 22 by mounting the third rail 32 to the second rail 30 along the second direction D2.

Therefore, the slide rail assembly 22 of the present invention is characterized in that:
1. When the third rail 32 is located at the extension position E relative to the second rail 30, the mounting hole 88 of the third rail 32 (such as a L-shaped or J- shaped hole), the first aperture 59 of the second rail 30, and the second aperture 79 of the sliding auxiliary device 74 are communicated with each other, such that the carried object 20 can be mounted to the slide rail assembly 22 without detaching the third rail 32 from the second rail 30; or, the third rail 32 can be detached from the second rail 30 to mount the carried object 20 to the third rail 32 first, and the third rail 32 is mounted to the second rail 30 thereafter. Therefore, the slide rail assembly 22 is configured to mount the carried object 20 in at least two different mounting ways, so as to allow the user to mount or detach the carried object 20 conveniently according to different requirements in a limited space.
2. Through engaging the engaging member 58 with the third rail 32, the second rail 30 and the third rail 32 can be synchronously moved along the first direction D1. After the extension part 66 of the engaging member 58 passes through the blocking part 50 of the releasing feature 38, the first guiding part 44 of the releasing feature 38 is configured to end the synchronous movement of the second rail 30 and the third rail 32.

## Claims

1. A slide rail assembly (22), comprising:
a first rail (28);
a second rail (30) movable relative to the first rail (28), the second rail (30) having a first aperture (59);
a third rail (32) movable relative to the second rail (30), the third rail (32) having a plurality of mounting holes (88a, 88b, 88c);
**characterized in that** it further comprises
a sliding auxiliary device (74) arranged between the second rail (30) and the third rail (32), the sliding auxiliary device (74) having a second aperture (79);
wherein when the third rail (32)is located at an extension position relative to the second rail (30), the first aperture (59), the second aperture (79) and one of the mounting holes (88a, 88b, 88c) of the third rail (32) are communicated with each other.

2. The slide rail assembly of claim 1, **characterized in that** the first rail (28) comprises a releasing feature (38), the slide rail assembly (22) further comprises an engaging member (58) pivoted to the second rail (30), the engaging member (58) is configured to engage with the third rail (32); wherein the second rail (30) and the third rail (32) are configured to be synchronously moved relative to the first rail (28) along a first direction when the engaging member (58) engages with the third rail (32), and the releasing feature (38) is configured to disengage the engaging member (58) from the third rail (32) when the second rail (30) is moved relative to the first rail (28) to a predetermined position.

3. The slide rail assembly of claim 2, further **characterized by** an elastic member (62) configured to provide an elastic force to the engaging member (58), wherein the third rail (32) comprises a first wall (80a), a second wall (80b) and a side wall (82) connected between the first wall (80a) and the second wall (80b), and the engaging member (58) is configured to abut against the first wall (80a) to be held in a first state in response to the elastic force of the elastic member (62) when the third rail (32) is located at a retracted position relative to the second rail (30).

4. The slide rail assembly of claim 3, **characterized in that** the third rail (32) has an opening (84) and a rail wall (86) adjacent to the opening (84), the engaging member (58) comprises an engaging part (64), the engaging member (58) is rotated from the first state to a second state in response to the elastic force of the elastic member (62) when the third rail (32) is moved relative to the second rail (30) along the first direction from the retracted position to a position, such that the engaging part (64) enters the opening (84) to correspond to the rail wall (86) for allowing the engaging member (58) to engage with the third rail (32).

5. The slide rail assembly of claim 4, **characterized in that** the second rail (30) has a through hole (56) facing toward the first rail (28), the engaging member (58) comprises an extension part (66) passing through the through hole (56), the releasing feature (38) comprises a first guiding part (44), the engaging member (58) is guided by the first guiding part (44) through the extension part (66) to be no longer in the second state when the second rail (30) is synchronously moved with the third rail (32) along the first direction to the predetermined position, so as to allow the engaging member (58) to be disengaged from the third rail (32).

6. The slide rail assembly of claim 5, **characterized in that** the releasing feature (38) further comprises a second guiding part (46), a linear part (48) and a blocking part (50), the blocking part (50) and the linear part (48) are located between the first guiding part (44) and the second guiding part (46), the extension part (66) of the engaging member (58) is moved along the second guiding part (46) when the second rail (30) is synchronously moved with the third rail (32) along the first direction to the predetermined position, the linear part (48), the blocking part (50) and the first guiding part (44), wherein each of the first guiding part (44) and the second guiding part (46) has an inclined face or an arc face, the blocking part (50) has a wall located between the first guiding part (44) and the linear part (48), the extension part (66) of the engaging member (58) is configured to be blocked by the blocking part (50) for preventing the second rail (30) from being moved relative to the first rail (28) along a second direction opposite to the first direction.

## Patentansprüche

1. Gleitschienenaufbau (22), welcher umfasst:
eine erste Schiene (28);
**gekennzeichnet durch**
eine zweite Schiene (30), die relativ zu der ersten Schiene (28) bewegbar ist, worin die zweite Schiene (30) eine erste Öffnung (59) aufweist;
eine dritte Schiene (32), die relativ zu der zweiten Schiene (30) bewegbar ist, worin die dritte Schiene (32) mehrere Befestigungslöcher (88a, 88b, 88c) aufweist; und
eine Gleit-Hilfseinrichtung (74), die zwischen der zweiten Schiene (30) und der dritten Schiene (32) angeordnet ist, worin die Gleit-Hilfseinrichtung (74) eine zweite Öffnung (79) aufweist;
worin wenn die dritte Schiene (32) relativ zu der zweiten Schiene (30) in einer Erstreckungsposition angeordnet ist, die erste Öffnung (59), die zweite Öffnung (79) und eines der Befestigungslöcher (88a, 88b, 88c) der dritten Schiene (32) miteinander in Verbindung stehen.

2. Gleitschienenaufbau nach Anspruch 1, **dadurch gekennzeichnet, dass** die erste Schiene (28) ein Freigabemerkmal (38) umfasst, worin der Gleitschienenaufbau (22) weiter ein Eingriffselement (58) umfasst, das zu der zweiten Schiene (30) schwenkbar ist, worin das Eingriffselement (58) ausgestaltet ist, mit der dritten Schiene (32) in Eingriff zu kommen; worin die zweite Schiene (30) und die dritte Schiene (32) ausgestaltet sind, relativ zu der ersten Schiene (28) entlang einer ersten Richtung gleichzeitig bewegt zu werden, wenn das Eingriffselement (58) mit der dritten Schiene (32) in Eingriff kommt, und worin das Freigabemerkmal (38) ausgestaltet ist, das Eingriffselement (58) von der dritten Schiene (32) außer Eingriff zu nehmen, wenn die zweite Schiene (30) relativ zu der ersten Schiene (28) in eine bestimmte Position bewegt wird.

3. Gleitschienenaufbau nach Anspruch 2, weiter **gekennzeichnet durch** ein elastisches Element (62), welches ausgestaltet ist, dem Eingriffselement (58) eine elastische Kraft zu liefern, worin die dritte Schiene (32) eine erste Wand (80a), eine zweite Wand (80b) und eine Seitenwand (82) umfasst, die zwischen der ersten Wand (80a) und der zweiten Wand (80b) verbunden ist, und worin das Eingriffselement (58) ausgestaltet ist, gegen die erste Wand (80a) anzustoßen, um als Reaktion auf die elastische Kraft des elastischen Elementes (62) in einem ersten Zustand gehalten zu werden, wenn die dritte Schiene (32) relativ zu der zweiten Schiene (30) in einer zurückgezogenen Position angeordnet ist.

4. Gleitschienenaufbau nach Anspruch 3, **dadurch gekennzeichnet, dass** die dritte Schiene (32) eine Öffnung (84) und eine Schienenwand (86) aufweist, die neben der Öffnung (84) vorgesehen ist, worin das Eingriffselement (58) ein Eingriffsteil (64) umfasst, worin das Eingriffselement (58) als Reaktion auf die elastische Kraft des elastischen Elementes (62) aus dem ersten Zustand in einen zweiten Zustand gedreht wird, wenn die dritte Schiene (32) relativ zu der zweiten Schiene (30) entlang der ersten Richtung aus der zurückgezogenen Position in eine Position bewegt wird, so dass das Eingriffsteil (64) in die Öffnung (84) gelangt, um mit der Schienenwand (86) in Verbindung zu kommen, damit das Eingriffselement (58) mit der dritten Schiene (32) in Eingriff kommen kann.

5. Gleitschienenaufbau nach Anspruch 4, **dadurch gekennzeichnet, dass** die zweite Schiene (30) ein Durchgangsloch (56) aufweist, das der ersten Schiene (28) zugewandt ist, worin das Eingriffselement (58) ein Erstreckungsteil (66) umfasst, das durch das Durchgangsloch (56) geht, worin das Freigabemerkmal (38) ein erstes Führungsteil (44) umfasst, worin das Eingriffselement (58) durch das erste Führungsteil (44) durch das Erstreckungsteil (66) geführt wird, um nicht weiter in dem zweiten Zustand zu sein, wenn die zweite Schiene (30) zeitgleich mit der dritten Schiene (32) entlang der ersten Richtung in eine bestimmte Position bewegt wird, damit das Eingriffselement (58) von der dritten Schiene (32) außer Eingriff genommen werden kann.

6. Gleitschienenaufbau nach Anspruch 5, **dadurch gekennzeichnet, dass** das Freigabemerkmal (38) weiter ein zweites Führungsteil (46), ein gerades Teil (48) und ein blockierendes Teil (50) umfasst, worin das blockierende Teil (50) und das gerade Teil (48) zwischen dem ersten Führungsteil (44) und dem zweiten Führungsteil (46) angeordnet sind, worin das Erstreckungsteil (66) des Eingriffselementes (58) entlang dem zweiten Führungsteil (46) bewegt wird, wenn die zweite Schiene (30) zeitgleich mit der dritten Schiene (32) entlang der ersten Richtung in eine bestimmte Position, dem geraden Teil (48), dem blockierenden Teil (50) und dem ersten Führungsteil (44) bewegt wird, worin jedes von dem ersten Führungsteil (44) und dem zweiten Führungsteil (46) eine geneigte Fläche oder eine bogenförmige Fläche aufweist, worin das blockierende Teil (50) eine Wand aufweist, die zwischen dem ersten Führungsteil (44) und dem geraden Teil (48) angeordnet ist, worin das Erstreckungsteil (66) des Eingriffselementes (58) ausgestaltet ist, durch das blockierende Teil (50) blockiert zu werden, um zu verhindern dass die zweite Schiene (30) relativ zu der ersten Schiene (28) entlang einer zweiten der ersten Richtung abgewandten/ entgegengesetzten Richtung bewegt wird.

## Revendications

1. Ensemble de rails coulissants (22), comprenant :
un premier rail (28) ;
un deuxième rail (30) mobile par rapport au premier rail (28), le deuxième rail (30) possédant une première ouverture (59) ;
un troisième rail (32) mobile par rapport au deuxième rail (30), le troisième rail (32) possédant une pluralité de trous de montage (88a, 88b, 88c) ;
**caractérisé en ce qu'**il comprend en outre
un dispositif auxiliaire coulissant (74) disposé entre le deuxième rail (30) et le troisième rail (32), le dispositif auxiliaire coulissant (74) possédant une deuxième ouverture (79) ;
où, lorsque le troisième rail (32) est situé au niveau d'une position d'extension par rapport au deuxième rail (30), la première ouverture (59), la deuxième ouverture (79) et l'un des trous de montage (88a, 88b, 88c) du troisième rail (32) sont en communication les uns avec les autres.

2. Ensemble de rails coulissants selon la revendication 1, **caractérisé en ce que** le premier rail (28) comprend un élément de libération (38), l'ensemble de rails coulissants (22) comprend en outre un élément de mise en prise (58) pivoté vers le deuxième rail (30), l'élément de mise en prise (58) est conçu pour venir en prise avec le troisième rail (32) ; le deuxième rail (30) et le troisième rail (32) étant conçus pour être déplacés de manière synchrone par rapport au premier rail (28) le long d'une première direction lorsque l'élément de mise en prise (58) vient en prise avec le troisième rail (32) et l'élément de libération (38) étant conçu pour désolidariser l'élément de mise en prise (58) et le troisième rail (32) lorsque le deuxième rail (30) est déplacé par rapport au premier rail (28) jusqu'à une position prédéterminée.

3. Ensemble de rails coulissants selon la revendication 2, **caractérisé en outre par** un élément élastique (62) conçu pour fournir une force élastique à l'élément de mise en prise (58), le troisième rail (32) comprenant une première paroi (80a), une deuxième paroi (80b) et une paroi latérale (82) reliée entre la première paroi (80a) et la deuxième paroi (80b) et l'élément de mise en prise (58) étant conçu pour venir en butée contre la première paroi (80a) à maintenir dans un premier état en réponse à la force élastique de l'élément élastique (62) lorsque le troisième rail (32) est situé au niveau d'une position rétractée par rapport au deuxième rail (30).

4. Ensemble de rails coulissants selon la revendication 3, **caractérisé en ce que** le troisième rail (32) présente une ouverture (84) et une paroi de rail (86) adjacente à l'ouverture (84), l'élément de mise en prise (58) comprend une partie de mise en prise (64), l'élément de mise en prise (58) est tourné du premier état dans un deuxième état en réponse à la force élastique de l'élément élastique (62) lorsque le troisième rail (32) est déplacé par rapport au deuxième rail (30) le long de la première direction depuis la position rétractée vers une position telle que la partie de mise en prise (64) pénètre dans l'ouverture (84) pour correspondre à la paroi de rail (86) afin de permettre une mise en prise de l'élément de mise en prise (58) avec le troisième rail (32).

5. Ensemble de rails coulissants selon la revendication 4, **caractérisé en ce que** le deuxième rail (30) présente un trou traversant (56) faisant face au premier rail (28), l'élément de mise en prise (58) comprend une partie d'extension (66) traversant le trou traversant (56), l'élément de libération (38) comprend une première partie de guidage (44), l'élément de mise en prise (58) est guidé par la première partie de guidage (44) à travers la partie d'extension (66) pour ne plus être dans le deuxième état lorsque le deuxième rail (30) est déplacé de manière synchrone avec le troisième rail (32) le long de la première direction vers la position prédéterminée, de façon à permettre la désolidarisation de l'élément de mise en prise (58) et du troisième rail (32).

6. Ensemble de rails coulissants selon la revendication 5, **caractérisé en ce que** l'élément de libération (38) comprend en outre une deuxième partie de guidage (46), une partie linéaire (48) et une partie de blocage (50), la partie de blocage (50) et la partie linéaire (48) sont situées entre la première partie de guidage (44) et la deuxième partie de guidage (46), la partie d'extension (66) de l'élément de mise en prise (58) est déplacée le long de la deuxième partie de guidage (46) lorsque le deuxième rail (30) est déplacé de manière synchrone avec le troisième rail (32) le long de la première direction vers la position prédéterminée, la partie linéaire (48), la partie de blocage (50) et la première partie de guidage (44), chacune de la première partie de guidage (44) et de la deuxième partie de guidage (46) présentant une face inclinée ou une face arquée, la partie de blocage (50) présentant une paroi située entre la première partie de guidage (44) et la partie linéaire (48), la partie d'extension (66) de l'élément de mise en prise (58) étant conçue pour être bloquée par la partie de blocage (50) pour empêcher le déplacement du deuxième rail (30) par rapport au premier rail (28) le long d'une deuxième direction opposée à la première direction.
